Europäisches Patentamt

European Patent Office

Office européen des brevets

(19)

(11) Publication number: **0 026 588**
**B1**

(12) **EUROPEAN PATENT SPECIFICATION**

(45) Date of publication of patent specification: **17.04.85**

(51) Int. Cl.⁴: **H 03 K 5/153**, H 03 K 17/13

(21) Application number: **80303119.4**

(22) Date of filing: **05.09.80**

(54) Zero-crossing comparators with threshold validation.

(30) Priority: **14.09.79 GB 7931927**

(43) Date of publication of application:
**08.04.81 Bulletin 81/14**

(45) Publication of the grant of the patent:
**17.04.85 Bulletin 85/16**

(84) Designated Contracting States:
**AT BE CH DE FR IT LI LU NL SE**

(56) References cited:
**US-A-3 639 779**
**US-A-3 718 864**
**US-A-3 768 024**

**U. TIETZE et al. "Halbleiter - Schaltungstechnik"
2nd. edition 1971, SPRINGER-VERLAG, Berlin,
Heidelberg, New York
IBM TECHNICAL DISCLOSURE BULLETIN Vol.
18, No. 1, June 1975 H. BRAQUET et al.
"Zero-Crossing Detector" page 144**

(73) Proprietor: **PLESSEY OVERSEAS LIMITED
Vicarage Lane
Ilford Essex IGI 4AQ (GB)**

(72) Inventor: **Galpin, Robert Keith Portway
J.W. Frisolaan 43
NL-2252 HD Voorschoten (NL)**

(74) Representative: **Hart, Robert John
Plessey Telecommunications Limited Edge Lane
Liverpool L7 9NW (GB)**

Courier Press, Leamington Spa, England.

## Description

Voltage comparators and other circuits for slicing analogue signals are well known in the art and employed in many situations. In some applications where the need exists to distinguish a valid signal from low level noise, a voltage threshold may be applied to the reference input of the comparator in order that only signals exceeding that threshold voltage will cause the comparator to switch. Unfortunately when this method is used, the transition of the comparator output will be delayed with reference to the zero-crossing of the input in one direction and advanced in the other direction by an amount depending upon the amplitude of the input signal. In some applications like carrier recovery and timing recovery systems in high performance data modems it is essential to preserve accurately the zero-crossing instant of the input while providing a threshold to prevent the comparator responding to signals of less than a predetermined amplitude.

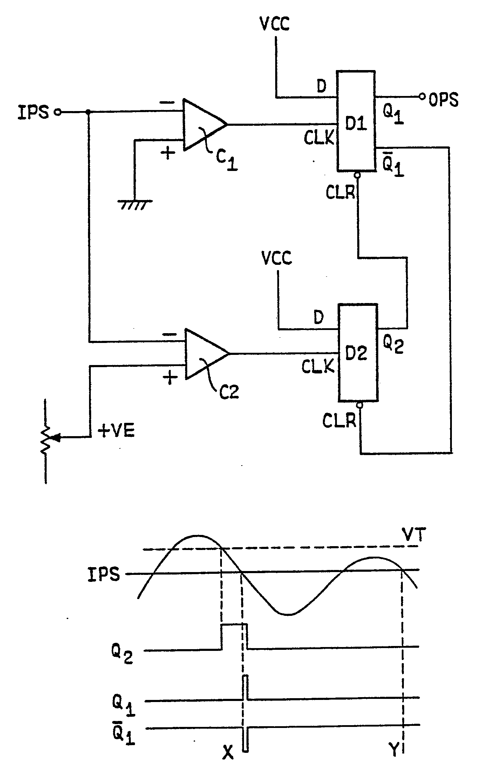

United States Patent No. 3,718,864, particularly at Figs. 3 and 5 and column 3 (line 7) to column 5 (line 16), discloses a circuit arrangement suitable for such purposes. Similarly U.S. Patent No. 3,639,779, at Figs. 1 and 2 and column 4 (lines 49 to 66) discloses a circuit arrangement adapted to generate an output signal when an input signal crosses zero on condition that the excursion of the input signal has exceeded a reference threshold signal during the previous half cycle.

It is an aim of the present invention to provide a circuit arrangement which produces an accurate and short duration indication of the zero-crossing instant.

According to the invention there is provided a circuit arrangement for use in carrier and timing recovery circuits of a digital data transmission system, the arrangement being adapted to generate an output signal when an input signal crosses zero on condition that the excursion of the input signal has exceeded a reference threshold signal during the previous half cycle, including first and second differential amplifiers both of which are connected to receive the input signal and further including a toggle characterised in that the first differential amplifier is arranged to produce an output signal when the input signal passes through zero in a first direction, the second differential amplifier being arranged to produce an output signal when the input signal falls in the said first direction below a predetermined threshold value, the output signal of the first differential amplifier is fed to the clock input of the toggle and the output signal of the second differential amplifier being fed to the clock input of a second toggle the first and second toggles are D type toggles of which the data inputs are held at a constant logic state level and which are interconnected such that the clear input of the first toggle is fed from the true output of the second toggle and the clear input of the second toggle is fed from the inverse output of the first toggle, the duration of the output pulse being defined by the time it takes to clear the first and second toggles.

In order that the invention may be more readily understood reference is made to the accompanying drawing which illustrates an embodiment of the present invention comprising two comparators and bistable storage elements which produce a narrow pulse in response to the negative zero-crossing transition of the input signal provided that the input signal has exceeded the positive reference threshold applied to the second comparator.

The drawing shows two differential amplifier comparators C1 and C2 driving a pair of "D" type toggles D1 and D2 which are interconnected so as to generate a narrow pulse on the output lead OPS when the input lead IPS passes through zero after having exceeded the positive threshold provided by the threshold level +VT. The output signals from the comparators C1 and C2 are connected respectively to the clock inputs of the "D" type toggles while the data inputs to the "D" type toggles are held at the logic "1" state level. The clear output Q2 from toggle D2 is used to control the clear input to toggle D1 while the inverse output $\overline{Q1}$ from toggle D1 is used to control the clear input to toggle D2. In operation when the positive half cycle of the input signal falls below the threshold level +VT toggle D2 is set by the output from causing comparator C2. This causes toggle D1 to be primed on its clear input by the "1" state signal on Q2. When the input waveform IPS reaches zero comparator C1 generates an output condition to switch D1 to the "1" state. The "0" transition on $\overline{Q1}$ causes toggle D2 to be cleared which in turn switches Q2 to the "0" state thereby clearing D1. The output signal OPS, therefore, exists for the time it takes to clear toggles D2 and D1.

The above description has concentrated on circuit arrangements operating on positive signals, whereas it will be obvious to those skilled in the art how the circuits could be amended to operate on negative half cycles.

## Claim

A circuit arrangement for use in carrier and timing recovery circuits of a digital data transmission system, the arrangement being adapted to generate an output signal (OPS) when an input signal (IPS) crosses zero on condition that the excursion of the input signal has exceeded a reference threshold signal (+VE) during the previous half cycle, including first (C1) and second (C2) differential amplifiers both of which are connected to receive the input signal (IPS) and further including a toggle (D1) characterised in that the first differential amplifier (C1) is arranged to produce an output signal when the input signal passes through zero in a first direction, the second differential amplifier (C2) being arranged to produce an output signal when the input signal falls in the said first direction below a predetermined threshold value, the output signal of the first differential amplifier (C1) is fed to the clock input (CLK) of the toggle (D1) and the output signal of the second differential amplifier (C2) being fed to the clock input of a second toggle (D2), the first (D1) and second (D2) toggles are D type toggles of which the data inputs (D) are held at a constant logic state level (VCC) and which are interconnected such that the clear input (CLR) of the first toggle (D1) is fed from the true output (Q2) of the second toggle and the clear input (CLR) of the second toggle is fed from the inverse output (Q̄1) of the first toggle, the duration of the output pulse being defined by the time it takes to clear the first (D1) and second (D2) toggles.

**Revendication**

Un agencement de circuit pour utilisation dans des circuit de récupération du rythme et de rètablissement de la porteuse d'un système de transmission de données numériques, cet agencement étant adapté pour produire un signal de sortie (OPS) lorsqu'un signal d'entrée (IPS) traverse le zéro à la condition que l'excursion du signal d'entrée ait dépassé un seuil de référence (positif) durant le demi cycle précédent, y compris le premier (C1) et le second (C2) amplificateurs différentiels, ces deux amplificateurs étant raccordés pour recevoir le signal d'entrée (IPS) et comprenant également un déclencheur bistable (D1) caractérisé en cela que le premier amplificateur différentiel (C1) est agencé pour produire un signal de sortie lorsque le signal d'entrée traverse zéro dans un premier sens, le second amplificateur différentiel (C2) étant agencé pour produire un signal de sortie lorsque le signal d'entrée tombe, dans le premier sens précité, au-dessous d'une valeur de seuil prédéterminée, le signal de sortie du premier amplificateur différentiel (C1) est alimenté à la sortie d'horloge (CLK) du déclencheur bistable (D1) et le signal de sortie du second amplificateur différentiel (C2) étant alimenté à l'entrée d'horloge d'un second déclencheur bistable (D2); le premier déclencheur bistable (D1) et le second déclencheur bistable (D2) sont des déclencheurs bistables de type D dont les entrées de données (D) sont maintenues à un niveau d'état logique constant (VCC) et qui sont interconnectées de telle sorte que l'entrée claire (CLR) du premier déclencheur bistable (D1) alimente la sortie vraie (Q2) du deuxième déclencheur bistable et que l'entrée claire (CLR) du deuxième déclencheur bistable alimente la sortie inverse (Q1) du premier déclencheur bistable, la durée de l'impulsion de sortie étant définie par le temps qu'elle prend pour dégager le premier (D1) et le second (D2) déclencheur bistable.

**Patentanspruch**

Schaltkreisanlage für die Verwendung in Träger- und Taktgleichaufschaltungen in digitalen Datenübertragungssystemen, wobei die Anlage dazu ausgelegt ist, bein Nulldurchgang eines Eingangssignals (IPS) ein Ausgangssignal (OPS) zu erzeugen, unter der Voraussetzung, daß die Amplitude des Eingangssignals während der vorausgehenden Halbperiode den Schwellenwert eines Referenzsignals (+ve) überschritt, einschließlich eines ersten (C1) und zweiten (C2) Differentialverstärkers, die beide für den Empfang des Eingangssignals (IPS) angeschlossen sind und zusätzlich einschließlich einer Kippschaltung (D1), dadurch gekennzeichnet, daß der erste Differentialverstärker (C1) ausgelegt ist, bein Nulldurchgang des Eingangssignals in einer ersten Richtung ein Ausgangssignals zu erzeugen, der zweite Differentialverstärker (C2) dazu ausgelegt ist, bein Abfall des Eingangssignals in besagter erster Richtung unter einen vorbestimmten Schwellwert ein Ausgangssignal zu erzeugen, wobei das Ausgangssignal des ersten Differentialverstärkers (C1) an den Takteingang (CLK) der Kippschaltung (D1) angelegt und das Ausgangssignal des zweiten Differentialverstärkers (C2) an den Takteingang einer zweiten Kippschaltung (D2) angelegt ist, wobei die erste (D1) und zweite (D2) Kippschaltung D-artige Kippschaltungen sind, deren Dateneingänge (D) auf einer konstanten logischen Ebene gehalten werden und die derart miteinander verbunden sind, daß der Rückstelleingang (CLR) der ersten Kippschaltung (D1) an den echten Ausgang (Q2) der Kippschaltung angelegt und der Rückstelleingang (CLR) der zweiten Kippschaltung an den invertierten Ausgang (Q̄1) der ersten Kipp-schaltung während der Dauer des Ausgangsimpulses angelegt wird, welche Dauer durch die für das Rückstellen der ersten (D1) und zweiten (D2) Kippschaltungen erforderlichen Zeit definiert wird.